# FASCICULE DE BREVET EUROPEEN

(11) **EP 1 016 117 B1**
(45) Date de publication et mention de la délivrance du brevet: **23.03.2005**
(21) Numéro de dépôt: 98925778.7
(22) Date de dépôt: 25.05.1998
(51) Int. Cl.: H01J 37/305, H01J 37/317

(54) **DISPOSITIF ET PROCEDE DE GRAVURE PAR IONS**
IONENÄTZ-VORRICHTUNG UND -VERFAHREN
DEVICE AND METHOD FOR ION BEAM ETCHING

(30) Priorité: 28.05.1997 FR 9706553
(43) Date de publication de la demande: 05.07.2000
(73) Titulaire: UNIVERSITE PIERRE ET MARIE CURIE, 75252 Paris Cédex 05 (FR)
(72) Inventeur: BRIAND, Jean-Pierre, F-92160 Antony (FR)
(74) Mandataire: Michelet, Alain
(86) Numéro de dépôt international: PCT/FR1998/001040
(87) Numéro de publication internationale: WO 1998/054747

(56) Documents cités:
- DE-C- 4 204 650
- US-A- 5 462 629
- BRIAND J -P ET AL: "Image acceleration of highly charged ions on metal, semiconductor, and insulator surfaces" PHYSICAL REVIEW A (ATOMIC, MOLECULAR, AND OPTICAL PHYSICS), APRIL 1997, APS THROUGH AIP, USA, vol. 55, no. 4, pages R2523-R2526, XP002055239 ISSN 1050-2947
- BRIAND J -P: "Above and below surface interactions of highly charged ions on metals, insulators or semiconductors" APPLICATION OF ACCELERATORS IN RESEARCH AND INDUSTRY. FOURTEENTH INTERNATIONAL CONFERENCE, DENTON, TX, USA, 6-9 NOV. 1996, no. 392, pt.1, pages 137-140, XP002055240 ISSN 0094-243X, AIP CONFERENCE PROCEEDINGS, 1997, AIP, USA cité dans la demande
- J.P. BRIAND: "Des ions très chargés sur les surfaces: les atomes creux" IMAGES DE LA PHYSIQUE,1992, pages 58-62, XP002055241 cité dans la demande

## Description

La présente invention se rapporte à un dispositif et un procédé de gravure par ions d'une surface d'un semi-conducteur ou isolant.

La gravure par ions nécessite un bon contrôle spatial de zones de gravure sur la surface de gravure. On peut avoir recours pour ce faire à un masque comportant des trous. Ces trous peuvent atteindre des taillés micrométriques et permettent une précision de gravure optimale de l'ordre d'une fraction ou moins de micron. Un inconvénient de cette technique est qu'elle implique la réalisation d'un masque pour chaque motif de gravure.

Une autre méthode repose sur un contrôle direct de la position relative du faisceau incident sur la surface de gravure. Ce contrôle est par exemple effectué au moyen de guidages électrique et/ou magnétique et d'un refroidissement du faisceau, c'est-à-dire de la réduction de la composante de la vitesse perpendiculaire à la direction de propagation du faisceau. La précision de cette méthode est encore améliorée en associant le contrôle direct à l'utilisation de micro- ou de nano-trous. Pour effectuer la gravure, on déplace le semi-conducteur ou isolant sous le faisceau. Cette technique améliore sensiblement la précision, qui atteint de l'ordre de quelques nm à 100 nm. La fiabilité de cette méthode est cependant limitée, à cause des difficultés posées par le choix de la durée d'exposition et de la vitesse de déplacement du semi-conducteur.

La présente invention a pour objectifs un dispositif et un procédé de gravure par ions d'une grande fiabilité, permettant un contrôle spatial précis de la gravure, pouvant être effectué électroniquement.

L'invention vise notamment un dispositif et un procédé de gravure par ions rendant possible une précision de gravure de l'ordre du nanomètre.

L'invention a pour but un tel dispositif et un tel procédé qui puissent être économiques et faciles à mettre en oeuvre.

A cet effet, l'invention concerne un dispositif de gravure par ions permettant de graver une surface de gravure d'un semi-conducteur ou isolant. Le dispositif comprend:
- une source d'ions positifs,
- des moyens de guidage d'un faisceau des ions dirigeant le faisceau vers la surface de gravure, et
- des moyens de déplacement relatif de la surface de gravure par rapport au faisceau d'ions.

Selon l'invention, le dispositif comprend:
- un système de détection spatio-temporel d'interactions d'ions du faisceau avec la surface de gravure,
- des moyens d'interruption du faisceau d'ions, et
- une unité de traitement reliée aux moyens de déplacement, au système de détection et aux moyens d'interruption de faisceau, commandant les opérations successives de détection d'interactions d'ions du faisceau avec la surface de gravure, d'interruption du faisceau, de déplacement relatif de la surface de gravure par rapport à la position du faisceau et de rétablissement du faisceau.

Selon l'invention, l'unité de traitement commande les opérations mentionnées ci-dessus de manière répétée.

Par « surface », on entend une partie superficielle du semi-conducteur ou isolant, généralement coupée approximativement selon un plan cristallographique. La surface est avantageusement plane, mais peut aussi être courbe.

Les opérations avec le faisceau d'ions sont effectuées sous vide. Ce vide peut correspondre à une pression relativement élevée, par exemple de l'ordre de 10⁻⁹ Pa. Il peut aussi être un ultravide.

Les moyens de déplacement relatif de la surface de gravure par rapport au faisceau d'ions peuvent impliquer un déplacement du semi-conducteur ou isolant ou un déplacement du faisceau, par variation de leur position ou de leur orientation. On effectue ainsi la gravure de manière successive, zone après zone. Dans une variante de mise en oeuvre, on dirige simultanément plusieurs faisceaux vers la surface.

Le système de détection spatio-temporelle détecte à la fois les positions et les instants des interactions.

Le dispositif de gravure selon l'invention permet par rapport aux dispositifs existants une maîtrise des durées d'exposition de la surface de gravure et des déplacements relatifs de la surface de gravure par rapport au faisceau d'ions. Cette maîtrise conduit à une fiabilité considérablement accrue. En effet, la principale difficulté de la gravure par ions réside dans le fait que l'arrivée des ions sur la cible est aléatoire, à la fois du point de vue spatiale et du point de vue temporel. Le dispositif selon l'invention permet d'adapter la gravure à ces phénomènes aléatoires.

Les ions positifs envoyés par la source sont de préférence multi-chargés, c'est-à-dire qu'ils ont chacun au moins trois charges positives.

Préférentiellement, les interactions des ions du faisceau avec la surface de gravure sont effectuées ion par ion.

Le semi-conducteur gravé est par exemple formé d'un matériau choisi parmi Si, AsGa, InP et Ge. L'isolant gravé est quant à lui par exemple formé par SiO₂ ou LiF.

Préférentiellement, le dispositif de gravure comprend un système de localisation spatiale du faisceau d'ions, interposé entre la source d'ions et la surface de gravure.

Ce système de localisation spatiale consiste avantageusement en un ou plusieurs collimateurs de faisceau.

Il est également avantageux que le dispositif de gravure soit équipé d'un système de contrôle de la position du faisceau, et de moyens de refroidissement du faisceau. Il est aussi intéressant que le dispositif comprenne un système de sélection monocinétique des ions (entre la source d'ions et la surface de gravure).

Les moyens d'interruption de faisceau comprennent avantageusement des moyens d'application d'un champ électrique approximativement parallèle à la surface de gravure.

Ce champ électrique est à même de dévier le faisceau et de bloquer ainsi l'arrivée d'un nouvel ion sur la surface. L'emploi du champ électrique d'interruption de faisceau est avantageusement combiné avec l'utilisation d'un collimateur, un faible champ électrique suffisant ainsi à interrompre le faisceau.

Dans une forme préférée des moyens de guidage, ceux-ci comprennent des moyens d'application d'un champ magnétique, déviant le faisceau d'ions d'un certain angle.

Avantageusement, ce champ magnétique est uniforme et l'angle de déviation vaut 90°.

Dans une première variante de réalisation, les moyens de guidage comprennent des moyens d'application d'un champ électrique produisant une déviation électrique.

Dans une seconde variante, les moyens de guidage mettent en oeuvre à la fois un champ magnétique et un champ électrique combinés, par exemple dans un filtre de Wien.

Les moyens de déplacement relatif de la surface de gravure par rapport au faisceau d'ions comprennent avantageusement au moins un élément choisi parmi un quartz piézo-électrique et une céramique, déplaçant le semi-conducteur par rapport au faisceau d'ions incident sur la surface de gravure.

De tels moyens de déplacement rendent possibles un mouvement contrôlé à une précision pouvant être de l'ordre du nanomètre. La présence de plusieurs moyens de déplacement complémentaires, tels que deux quartz piézo-électriques ou deux céramiques, permet de déplacer le semi-conducteur ou l'isolant dans deux directions perpendiculaires entre elles, ce qui rend possible la réalisation de n'importe quel motif de gravure. On peut ainsi, par exemple, créer le long d'une ligne rectiligne ou circulaire des points isolants sur un semi-conducteur ou des points semi-conducteurs sur un isolant à des distances régulières afin de réaliser un codage digital.

Préférentiellement, le déplacement du semi-conducteur est perpendiculaire au faisceau d'ions incident.

Il peut cependant aussi être effectué avec n'importe quel angle par rapport au faisceau incident.

Il est intéressant que le dispositif de gravure comprenne un microscope à effet tunnel et/ou à force atomique, effectuant un contrôle local topographique et/ou de conductivité électrique de la surface de gravure traitée.

D'une manière générale, un tel microscope permet la lecture d'un motif de gravure.

Le dispositif de gravure selon l'invention est applicable à n'importe quelle surface de gravure, passivée ou non, et est valable pour tout principe de gravure suivant lequel la nature électrique ou chimique ou la topographie de la surface est localement modifiée par un faisceau d'ions.

Dans un premier mode de réalisation préférée du dispositif de gravure selon l'invention, la surface est occupée par des premières molécules du semi-conducteur ou isolant ayant une première nature chimique ou topographique. La source d'ions est une source d'ions positifs fortement chargés et à basse énergie, et le dispositif de gravure comprend des moyens d'application d'une tension de décélération, donnant aux ions du faisceau une vitesse moyenne commandée, permettant à ces ions, sans rentrer en contact avec la surface de gravure, de transformer une pluralité des premières molécules de la surface en des secondes molécules ayant une seconde nature chimique ou topographique, ces ions étant rétrodiffusés.

Par ions positifs « fortement chargés », on entend des ions ayant au moins trois charges positives, et préférentiellement au moins quinze charges positives. Leur énergie est dite « basse » par rapport à celle d'ions obtenus au moyen d'un accélérateur de particules, cette dernière énergie étant de l'ordre du MeV ou du GeV. La faible énergie des ions est ainsi inférieure à quelques dizaines de keV.

La tension de décélération est appliquée de façon à pouvoir donner aux ions une énergie très faible, pouvant approcher 0 et généralement inférieure à quelques dizaines d'eV. La décélération des ions peut se faire sur la cible, par polarisation de celle-ci, ou à n'importe quel endroit de la ligne, par polarisation de la ligne.

Un aspect important de ce mode de réalisation du dispositif selon l'invention est que les ions ne rentrent pas en contact avec la surface mais au contraire, attirent à eux ou excitent des électrons de surface, puis repartent en sens opposé.

L'interaction des ions avec la surface de gravure peut s'effectuer de deux manières, selon notamment la nature et la disposition des premières molécules, la valeur de la tension de décélération et le nombre de charges des ions. Selon une première forme d'interaction, préférée, les ions extraient des électrons de la pluralité des premières molécules, deviennent des atomes creux et sont rétrodiffusés. Selon une seconde forme d'interaction, les ions provoquent une excitation ou une extraction des électrons, causant directement une expulsion de fragments de la pluralité des premières molécules (sputtering).

L'extraction d'électrons d'un semi-conducteur ou isolant par des ions fortement chargés et à basse énergie est explicitée dans l'article de Jean-Pierre BRIAND présenté à la Quatorzième Conférence Internationale des Applications d'Accélérateurs dans la Recherche et l'Industrie, DENTON-TEXAS, 6-9 Novembre 1996. De manière schématique, un ion fortement chargé et à basse énergie commence à interagir avec le milieu semi-conducteur ou isolant à une distance relativement importante de la surface, pouvant atteindre plusieurs dizaines d'Å 1Å = 0,1 nm. L'ion attire et capture alors des électrons de conduction ou de valence qui viennent occuper les états de Rydberg de l'ion. L'ion devient ainsi un atome creux (hollow atom), c'est-à-dire un atome ayant des couches internes au moins partiellement vides et des couches externes occupées par des électrons excités. Le nombre d'électrons capturés par l'ion est considérablement plus élevé que sa charge, car une partie de ces électrons sont ensuite expulsés de l'ion par effet Auger. Le nombre d'électrons arrachés au semi-conducteur par un ion est généralement égal à environ trois fois sa charge.

A proximité de la surface, l'ion génère une image électrique (de charge négative) qui exerce une force d'attraction sur l'ion et tend ainsi à accélérer son mouvement vers la surface. Cependant, l'extraction d'électrons par l'ion crée sur des semi-conducteurs ou des isolants des trous positifs à la surface, qui compensent cette image électrique. L'atome creux formé à partir de l'ion peut alors être rétrodiffusé (back scattered) sans contact au-dessus de la surface, par « effet trampoline ». L'existence ou non de contact et de pénétration à l'intérieur du matériau semi-conducteur dépend des conditions cinématiques initiales de l'ion: au-dessus d'une vitesse critique, l'ion dirigé vers la surface atteint et pénètre le matériau semi-conducteur en dépit de la formation des trous positifs. En revanche, l'effet trampoline se produit en deçà de cette vitesse critique. La vitesse critique a une valeur dépendant du potentiel d'extraction du matériau semi-conducteur et de la charge initiale de l'ion positif.

La commande de la vitesse moyenne des ions au moyen de la tension de décélération permet de produire l'effet trampoline et de donner aux ions une charge et une énergie maîtrisées.

Après un certain trajet, les atomes creux deviennent souvent spontanément, par cascades Auger, des ions creux. Pour simplifier, nous parlerons systématiquement d'atomes creux pour désigner les atomes creux restés des atomes ou redevenus des ions.

La transformation des premières molécules en les secondes molécules peut prendre différentes formes, selon notamment la nature et la disposition des premières molécules, la valeur de la tension de décélération et le nombre de charges des ions.

Dans une première forme de transformation, les premières molécules ont une première nature chimique et les secondes molécules ont une seconde nature chimique. L'extraction d'électrons des premières molécules conduit à l'expulsion de certains atomes de ces premières molécules, qu'on remplace ou non par d'autres atomes ou molécules, en envoyant ou non un produit approprié.

Selon une réalisation préférée du dispositif de gravure selon l'invention, correspondant à cette première forme de transformation, le changement de nature chimique provoque un changement de nature électrique. Dans un premier mode de cette réalisation préféré, les premières molécules sont semi-conductrices et les secondes molécules sont isolantes, et sont par exemple respectivement constituées de SiH et de SiO₂. Dans un second mode de cette réalisation préférée, les premières et secondes molécules sont respectivement isolantes et semi-conductrices, et sont par exemple respectivement constituées de SiO₂ et de Si.

Dans une seconde forme de transformation, les premières molécules ont une première nature topographique et les secondes molécules ont une seconde nature topographique. Préférentiellement, les premières molécules forment alors une surface plate, et l'interaction des ions génère la formation de pointes et de trous.

Avantageusement, selon une réalisation particulière du premier mode de réalisation avec changement de nature électrique, les premières molécules ont des liaisons extérieures saturées par des atomes d'hydrogène. Les moyens d'application de la tension de décélération permettent aux ions du faisceau d'extraire des électrons de la pluralité des premières molécules de la surface et de faire perdre ainsi à la pluralité des premières molécules leurs atomes d'hydrogène et de rendre pendantes les liaisons extérieures correspondantes. Les ions deviennent des atomes creux après avoir extrait des électrons et sont rétrodiffusés. De plus, le dispositif de gravure comprend une source d'un produit saturant les liaisons extérieures pendantes de façon à former les secondes molécules, ces secondes molécules étant isolantes, la source envoyant le produit vers la surface de gravure suite à un passage du faisceau d'ions.

Les électrons extraits de la surface du semi-conducteur sont essentiellement des électrons participant aux liaisons extérieures des premières molécules. En leur absence, les atomes d'hydrogène saturant les liaisons extérieures se retrouvent réduits à des protons qui ne sont plus liés à la surface. Les liaisons extérieures deviennent ainsi pendantes.

Dans cette réalisation du dispositif de gravure selon l'invention, contrairement à la méthode consistant à former des boursouflures (blisters) par des chocs d'ions, on ne modifie pas la topographie de la surface mais sa conductivité. En effet, alors que les premières molécules sont semi-conductrices, les secondes molécules sont isolantes. Il est ainsi possible de générer des marques isolantes de l'ordre du nanomètre, ce qui permet d'obtenir une augmentation de stockage d'informations de l'ordre de 100² ou plus par rapport aux techniques existantes. De plus, il est aisé et rapide de contrôler localement la conductivité de la surface après gravure, au moyen d'un microscope à effet tunnel.

Dans une première forme avantageuse de la réalisation préférée de ce premier mode de réalisation, le système de détection comporte un appareil de mesure de photons émis, lors de passages des électrons extraits d'une couche électronique à un autre des atomes creux.

Cet appareil mesure avantageusement les rayons X émis. En effet, les électrons capturés dans les atomes creux et non expulsés descendent vers des couches plus profondes en provoquant l'émission de rayons X, le remplissage des couches internes générant des marques temporelles espacées de quelques dixièmes de femto-secondes. Ces phénomènes sont décrits dans l'article de Jean-Pierre BRIAND précédemment cité, ainsi que dans un article de Jean-Pierre BRIAND et Coll. paru dans Images de la Physique, 1992, pages 58-62.

Les photons mesurés par l'appareil de mesure peuvent aussi consister en des ultra-violets, de la lumière visible ou de l'infra-rouge.

Dans une seconde forme avantageuse de la réalisation préférée du premier mode de réalisation, le système de détection détecte des électrons émis par effet Auger par les atomes creux.

Dans une forme préférée du premier mode de réalisation, le système de détection comporte une surface de détection détectant des propriétés de particules heurtant la surface de détection et les ions ou atomes creux rétrodiffusés sont dirigés par les moyens de guidage vers la surface de détection.

Dans cette forme de détection reposant sur la détection des ions ou atomes creux, un signal est produit après une durée de vol, par exemple de l'ordre de la microseconde, entre l'interaction d'un ion avec la surface de gravure et la détection de cet ion ou de l'atome creux correspondant.

Les propriétés détectées consistent préférentiellement en la position, la vitesse et la charge des atomes creux rétrodiffusés.

Ce mode de détection est particulièrement avantageux, car un signal est systématiquement produit à chaque interaction, l'ion ou l'atome creux rétrodiffusé ayant une trajectoire bien définie et étant facile à détecter.

Les modes de réalisation qui suivent peuvent s'appliquer à une surface de gravure du type de celle de la méthode précédente, occupée par exemple par un composé du semi-conducteur et d'hydrogène, mais sont aussi applicables à d'autres types de surfaces, notamment formées de composés lamellaires.

Dans un deuxième mode de réalisation du dispositif de gravure selon l'invention, le système de détection détecte des fragments ionisés de molécules de la surface de gravure, expulsés sous l'effet des interactions. Il peut s'agir par exemple d'atomes de silicium dessoudés de la cible à distance ou au contact.

Lorsque le premier et le deuxième modes de réalisation sont combinés, le système de détection détecte des fragments ionisés de la pluralité des premières molécules. Ces fragments consistent avantageusement, pour la réalisation préférée, en des noyaux des atomes d'hydrogène perdus par la pluralité des premières molécules.

Ces protons émis et éventuellement réaccélérés lors du détachement de l'hydrogène de la surface peuvent signer temporellement un impact.

Dans un troisième mode de réalisation du dispositif de gravure, le système de détection détecte une gerbe d'électrons émis sous l'effet des interactions.

Dans un quatrième mode de réalisation du dispositif de gravure, le système de détection comporte un appareil de mesure de photons émis par des atomes de la surface de gravure.

Dans un cinquième mode de réalisation du dispositif de gravure, le système de détection détecte une charge électrique générée dans le semi-conducteur par les interactions.

Le système de détection peut mettre en oeuvre simultanément plusieurs des techniques de détection, afin d'obtenir des informations complémentaires ou de les conforter.

L'invention a également pour objet un procédé de gravure par ions permettant de graver une surface de gravure d'un semi-conducteur ou isolant. Dans ce procédé:
- on produit des ions positifs,
- on envoie un faisceau de ces ions vers des moyens de guidage,
- on dirige le faisceau d'ions vers la surface de gravure avec les moyens de guidage,
- on effectue des déplacements relatifs de la surface de gravure par rapport au faisceau d'ions.

Selon l'invention, pour graver la surface de gravure, on effectue de manière répétée les opérations suivantes:
- on fait une détection spatio-temporelle d'interactions d'ions du faisceau avec la surface de gravure,
- on interrompt le faisceau d'ions,
- on effectue un déplacement relatif de la surface de gravure par rapport à la position du faisceau, et
- on rétablit le faisceau d'ions.

L'invention sera illustrée et mieux comprise à l'aide de modes de mise en oeuvre et de réalisation de l'invention donnés ci-dessous en référence aux dessins annexés, sur lesquels:
La Figure 1A montre une plaquette de semi-conducteur destinée à subir le procédé de gravure selon l'invention.
La Figure 1B montre la plaquette de la Figure 1A après prétraitement.
La Figure 1C montre la plaquette des Figures 1A et 1 B après gravure.
La Figure 2 est un schéma synoptique des différentes étapes d'un prétraitement permettant de passer de la plaquette de la Figure 1A à celle de la Figure 1B et d'un mode de mise en oeuvre du procédé de gravure selon l'invention permettant de passer de la plaquette de la Figure 1B à celle de la Figure 1C.
La Figure 3 représente un mode de réalisation d'un dispositif de gravure selon l'invention, permettant d'appliquer le procédé schématisé à la Figure 2.
La Figure 4 représente l'interaction d'un ion positif fortement chargé avec la surface de la plaquette de la Figure 1B, lors de l'application du procédé de la Figure 2 avec le dispositif de la Figure 3.

Une plaquette 1 de semi-conducteur, visible sur la Figure 1A, est coupée selon une surface 2. La plaquette 1 est par exemple formée de silicium, exemple avantageux que nous conserverons dans la suite de l'exposé. Le semi-conducteur constituant la plaquette 1 peut être du silicium pur ou dopé P ou N à diverses concentrations, la concentration de dopage étant avantageusement comprise entre 10¹⁵ et 10¹⁸ atomes implantés par cm³.

La surface 2 a un état oxydé dû à l'exposition à l'air de la plaquette 1. Le semi-conducteur étant du silicium, les molécules de SiO₂ sont ainsi formées en surface, sur cinq à six couches atomiques. Par « surface », on désigne en réalité une partie superficielle de la plaquette 1 ayant une épaisseur très faible e1, et occupée par les molécules de SiO₂. L'épaisseur e1 vaut approximativement 20 Å.

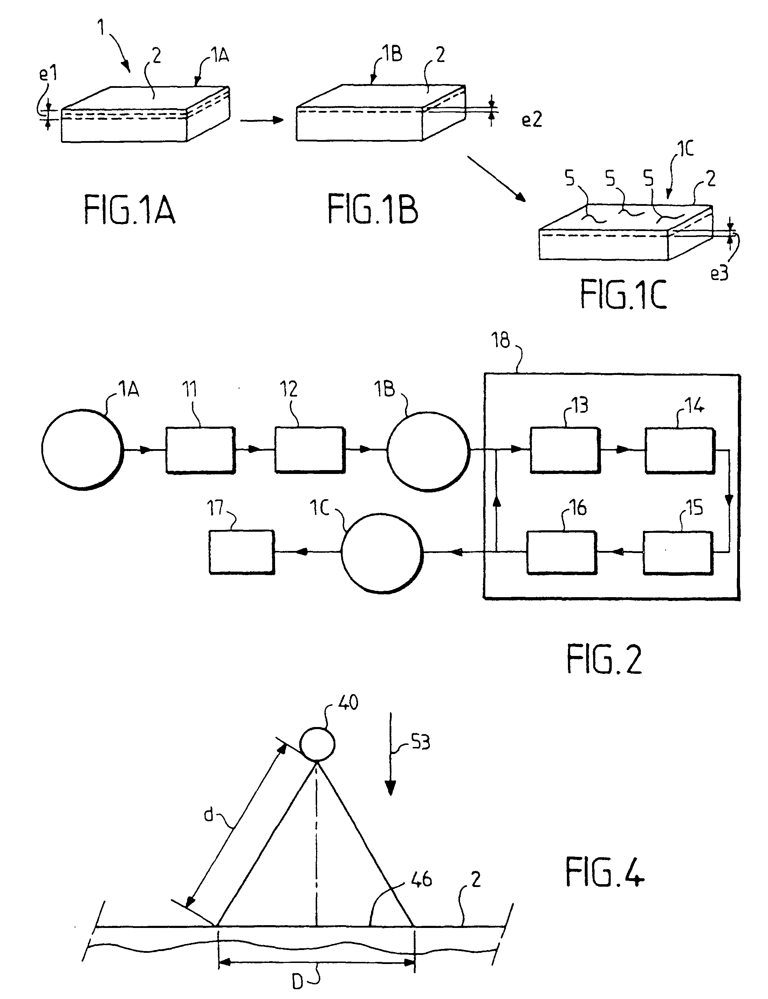

On applique à la plaquette 1 sous cette forme initiale 1A un prétraitement permettant de décaper la surface 2 et de la recouvrir d'une monocouche d'hydrogène. Ce prétraitement comprend deux étapes 11 et 12, apparaissant sur la Figure 2. Selon la première étape 11 du prétraitement, on plonge la plaquette 1 dans un premier bain, d'acide fluorhydrique, puis dans la seconde étape 12 du prétraitement, on la plonge dans un second bain, d'acide fluorhydrique et comportant des ions d'ammonium. De cette manière, on produit un décapage de la surface 2 qui élimine l'oxygène combiné en surface aux molécules du semi-conducteur de la plaquette 1. On crée ainsi des liaisons extérieures pendantes qu'on sature aussitôt par de l'hydrogène.

Le prétraitement conduit à un état prétraité 1 B de la plaquette 1 (Figures 1 B et 2), dans lequel la surface 2 est extrêmement bien passivée et plane et est occupée par des molécules de SiH sur une épaisseur e2. Les atomes d'hydrogène occupent alors une couche atomique unique au-dessus de la plaquette 1. On soumet ensuite la plaquette 1 à un ensemble d'opérations, visant à remplacer de manière sélective une partie des molécules SiH de la surface 2 par des molécules de SiO₂, tout en conservant une excellente définition et une extrême propreté de la surface 2. On produit ainsi une gravure de la plaquette 1, comme on peut le voir sur la Figure 1C. Les zones déterminées de la surface 2 étant occupées par des pointes ou marques isolantes de SiO₂, forment alors un réseau constitué de parties isolantes 5, les zones complémentaires de la surface 2 restant occupées par des molécules de SiH.

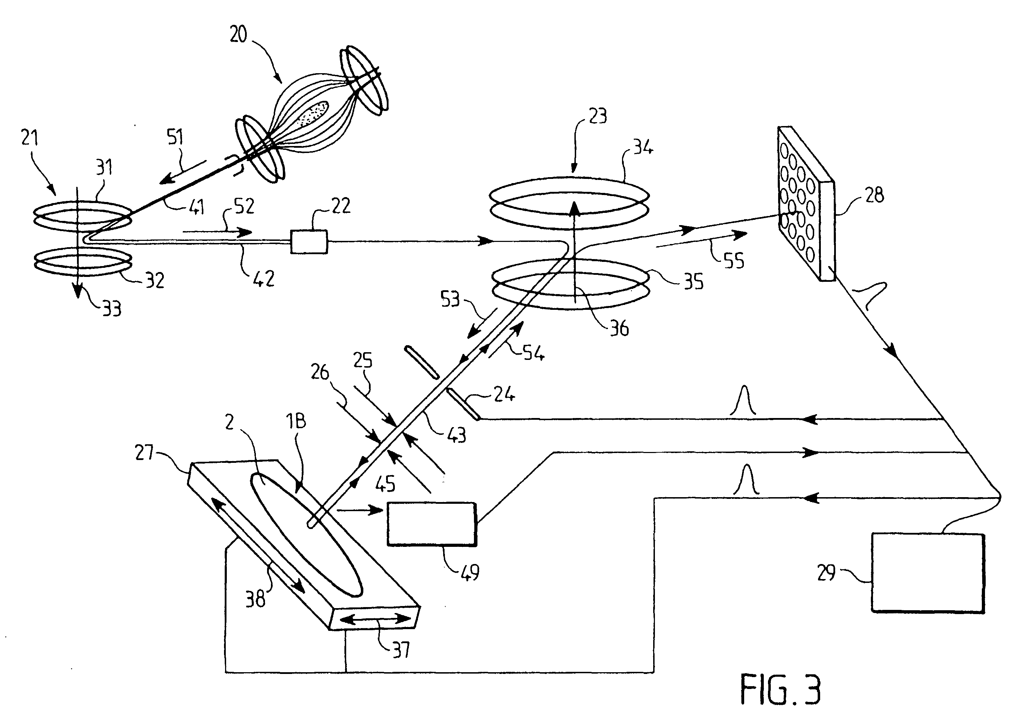

Pour appliquer ces opérations, on a recourt à un dispositif de gravure, représenté sur la Figure 3. Ce dispositif comprend une source d'ions 20 produisant des ions positifs fortement chargés et à basse énergie. La source d'ions 20 peut utiliser une préparation des ions à l'intérieur d'un plasma très chaud confiné dans des structures magnétiques, telles qu'une source ECR (Electron Cyclotron Resonance). Elle peut aussi avoir pour principe de fonctionnement la compression de faisceaux d'électrons dans un solénoïde, des atomes injectés dans le faisceau d'électrons étant simultanément ionisés et piégés par charge d'espace. La source d'ions 20 peut ainsi être du type EBIS (Electron Beam Ion Source).

Les ions émis par la source d'ions 20 peuvent être par exemple de l'argon, chargé Ar¹⁷⁺ ou Ar¹⁸⁺, de l'oxygène ou de l'uranium. Le nombre de charges positives peut varier de quelques unités à 92 pour l'uranium.

La source d'ions 20 produit ainsi un faisceau 41 des ions selon une première direction 51. Ce faisceau 41 est dirigé vers des moyens de sélection d'une espèce ionique choisie, par exemple Ar¹⁷⁺. Les moyens de sélection consistent avantageusement en des premiers moyens d'application 21 d'un champ magnétique 33, qui comprend deux bobines 31 et 32 en vis-à-vis ou aimants permanents. Le champ magnétique 33 est avantageusement uniforme. Il peut aussi être non uniforme de façon à être focalisant. Le champ magnétique 33 est avantageusement perpendiculaire à la direction 51 du faisceau 41 incident. Les moyens de sélection produisent ainsi un faisceau 42 des ions sélectionnés, dans une direction 52.

Dans une variante de réalisation, les moyens de sélection sont des moyens d'application d'un champ électrique.

Le dispositif de gravure comprend préférentiellement un système de contrôle direct de position du faisceau 42, référencé 22. Ce système de contrôle direct 22 comprend par exemple un système de refroidissement à électrons ou photons ou un système d'utilisation du mouvement synchrotron. Il a pour effet de diminuer l'énergie transverse des ions dans le faisceau 42.

Le faisceau 42 est dirigé vers des moyens de guidage, guidant le faisceau 42 vers la surface 2 de gravure. Ces moyens de guidage consistent avantageusement en des seconds moyens d'application 23 d'un champ magnétique uniforme 36, comprenant deux bobines 34 et 35 en vis-à-vis ou aimants permanents. Le champ magnétique 36, étant de préférence perpendiculaire à la direction 52 de propagation du faisceau 42, dirige ainsi le faisceau 42 dans une direction 53 vers la surface 2, préférentiellement en incidence normale.

Dans une variante de réalisation, les moyens de guidage consistent en des moyens d'application d'un champ électrique, statique ou pulsé.

Le dispositif de gravure comprend ensuite des moyens d'interruption du faisceau 42, comportant avantageusement un obturateur 24 de faisceau à commande électronique. Cet obturateur 24 est destiné à interrompre le faisceau 42 lorsqu'une gravure est détectée sur la surface 2.

Dans une variante de réalisation, l'obturateur 24 est remplacé par des moyens d'application d'un champ électrique perpendiculaire à la direction 53 du faisceau 42, l'application et la suppression de ce champ électrique jouant respectivement le rôle de la fermeture et l'ouverture de l'obturateur 24.

Le dispositif de gravure comprend aussi, avantageusement, un système de localisation spatiale du faisceau 42, consistant par exemple en un ou plusieurs collimateurs 25, 26. Pour une gravure de haute précision, les collimateurs sont nanométriques.

Le semi-conducteur 1B faisant office de cible est monté sur un translateur 27, qui permet des mouvements selon deux directions 37 et 38 orthogonales entre elles, et perpendiculaires à la direction 53 du faisceau 42. Le translateur 27 comprend par exemple deux quartz piézo-électriques ou deux céramiques.

Un champ électrique de décélération des ions du faisceau 42 est appliqué au voisinage de la cible, par polarisation de celle-ci. Ce champ électrique décélère suffisamment les ions du faisceau 42 pour que ceux-ci extraient des électrons de la surface 2 sans contact avec cette surface et soient rétroréfléchis sous forme d'atomes creux (ou ions creux). Les ions émis par la source d'ions 20 ayant une énergie de l'ordre de plusieurs keV/q par exemple compris entre 5 et 20 keV/q, q désignant le nombre de charges positives de chacun de ces ions, ce champ électrique de décélération donne aux ions une énergie comprise entre 0 et quelques eV/q de manière contrôlée. L'application du champ électrique peut être effectuée au moyen d'un condensateur plan avec potentiomètre. Le contrôle de la tension de décélération permet de maîtriser la distance d'approche de chaque ion par rapport à la surface 2 et donc la taille de la zone élémentaire d'interaction décapée par cet ion.

Dans une variante de réalisation, la décélération n'est pas effectuée sur la cible mais à un endroit quelconque de la ligne de faisceau, par polarisation de la ligne.

Les atomes creux rétroréfléchis par la surface 2 forment un faisceau 43, qui part dans une direction 54 parallèle à la direction 53 et en sens opposé au faisceau 42. Le faisceau 43 d'atomes creux traverse ainsi les collimateurs 25 et 26, l'obturateur 24 et les moyens d'application 23 du champ magnétique 36, dans l'exemple illustré. Ce champ magnétique 36 dévie le faisceau 43 dans une direction 55, vers une surface de détection 28.

La surface de détection 28 donne la position, et avantageusement la vitesse et la charge, des atomes creux du faisceau 43 incident. Cette surface de détection 28 peut être par exemple un réseau de chaneltrons.

Le dispositif de gravure comporte avantageusement un appareil de mesure 49 de photons, notamment de rayons X, émis lors de passages d'électrons d'une couche électronique à une autre des atomes creux du faisceau 43.

Les faisceaux 41, 42 et 43 et la surface 2 de la plaquette 1 sont préservés de l'air ambiant par une enceinte de mise sous vide.

Le dispositif de gravure comprend aussi une unité de traitement 29 raccordée à l'obturateur 24, au translateur 27, à la surface de détection 28 et à l'appareil de mesure 49. Cette unité de traitement 29 reçoit des signaux en provenance de la surface de détection 28 et de l'appareil de mesure 49, et est à même de commander l'ouverture et la fermeture de l'obturateur 24 ainsi que des déplacements du translateur 27.

Le dispositif de gravure est préférentiellement complété par un microscope à effet tunnel et/ou par un microscope à force atomique, effectuant des contrôles locaux de conductivité topographique et/ou électrique de la surface 2 traitée.

En fonctionnement, lors de l'étape de gravure 18 (Figure 2), on effectue successivement les opérations suivantes. On produit un faisceau 41 d'ions positifs fortement chargés et à basse énergie au moyen de la source d'ions 20, on sélectionne une espèce ionique de ce faisceau 41 par les moyens d'application 21 du champ magnétique 33, on guide le faisceau 42 obtenu vers la surface 2 par les moyens d'application 23 du champ magnétique 36 en effectuant un contrôle direct de position par le système 22 et une localisation spatiale par le collimateur 25 et 26 et on décélère le faisceau 42.

Lorsque les ions du faisceau 42 sont suffisamment proches de la surface 2, ils commencent à interagir avec celle-ci. Les ions peuvent capturer les électrons de la plaquette 1 dès qu'ils parviennent dans une zone de capture s'étendant jusqu'à une distance d au-dessus de la surface 2. Ainsi, dès qu'un ion 40 pénètre dans la zone de capture, il interagit avec une portion 46 de cette surface 2 définissant approximativement un disque de diamètre D ayant des contours à une distance d de l'ion 40, comme représenté sur la Figure 4. Le diamètre D de la portion 46 d'interaction ne dépasse donc pas 2 d. L'ion 40 attire et extrait des électrons superficiels de la portion 46 tout au long de son approche dans la zone de capture. On commande cette approche en ajustant l'énergie cinétique de l'ion 40 grâce au champ électrique de décélération. L'ion 40 capture des électrons qui le transforment en un atome creux. Cet atome creux est ensuite rétrodiffusé sans contact par effet trampoline et on le dirige vers la surface de détection 28.

Les ions peuvent également exciter des atomes de la surface de gravure 2 à une distance plus grande que la distance d, c'est-à-dire en dehors de la zone de capture. Ils induisent ainsi des modifications de surface.

L'extraction d'électrons de la surface 2 provoque la disparition à cette surface 2 des atomes d'hydrogène saturant les liaisons extérieures correspondantes. Ces liaisons extérieures deviennent ainsi pendantes. On envoie alors sur la zone décapée un produit saturant les liaisons extérieures pendantes, de façon à former des molécules d'un composé isolant. Une façon simple de procéder consiste pour cela à appliquer un vide partiel dans l'enceinte de mise sous vide, de l'ordre de 10⁻⁹ Pa. De l'oxygène présent dans l'enceinte sature alors immédiatement les liaisons pendantes, de manière à former le composé isolant.

La gravure repose sur la succession et la répétition de quatre opérations 13-16, commandées par l'unité de traitement 29.

Dans une première opération 13, on détecte l'arrivée sur la surface de détection 28 d'atomes creux rétrodiffusés par la surface 2, après un temps de vol. L'unité de traitement 29 reçoit un signal d'impact correspondant à cette détection. Dans une deuxième opération 14, on interrompt alors l'arrivée du faisceau 42 sur la cible, en commandant la fermeture de l'obturateur 24. Dans une troisième opération 15, on déclenche ensuite la mise en mouvement contrôlée du translateur 27, sur une distance avantageusement de l'ordre du nanomètre. Dans une quatrième opération 16, on commande l'ouverture de l'obturateur 24, de telle sorte que le faisceau 42 peut de nouveau parvenir sur la surface 2.

Par la répétition des opérations 13 à 16, on produit une gravure dans les zones correspondant aux parties isolantes 5 prédéterminées. On obtient ainsi l'état 1C de la plaquette 1 , par une succession de décapages locaux à des endroits bien définis.

Avantageusement, l'appareil de mesure 49 envoie à l'unité de traitement 29 des informations complémentaires sur l'extraction d'électrons de la surface 2.

Préférentiellement, on effectue lors d'une étape ultérieure 17 un contrôle local de conductivité électrique et/ou topographique de la surface 2, au moyen des microscopes à effet tunnel et à force atomique.

Dans une variante de mise en oeuvre, on forme plusieurs couches de composé isolant dans les parties isolantes 5, le nombre de couches étant préférentiellement inférieur à 5. Par exemple, on contrôle pour cela la pression ou l'injection partielle du produit saturant.

Dans un mode de mise en oeuvre avantageux, on recouvre ensuite la surface 2 d'un revêtement quelconque, par exemple conducteur.

Dans d'autres modes de mise en oeuvre, la surface de détection 28 est remplacée par, ou associée à, un système de détection détectant des électrons émis par effet Auger par les atomes creux, des noyaux d'hydrogène décapés ou des atomes de semi-conducteur de la cible expulsés de la surface 2, une gerbe d'électrons émis, des photons émis par des atomes de la surface de gravure ou une charge électrique apparaissant sur la cible.

Certains de ces modes de réalisation sont utilisables non seulement pour des interactions sans contact entre le faisceau d'ions et la cible, mais aussi pour des implantations d'ions définitives ou transitoires dans le semi-conducteur 1. Dans ce dernier cas, la décélération des ions n'est pas nécessaire et ceux-ci peuvent arriver avec plus d'énergie sur la surface 2.

Plusieurs de ces modes de réalisation sont également applicables non seulement à un semi-conducteur, mais aussi à un isolant.

## Revendications

1. Dispositif de gravure par ions permettant de graver une surface de gravure (2) d'un semi-conducteur (1) ou isolant, le dispositif comprenant:
- une source (20) d'ions positifs,
- des moyens de guidage (23) d'un faisceau (42) desdits ions (40) dirigeant ledit faisceau (42) vers la surface de gravure (2), et
- des moyens de déplacement relatif (27) de la surface de gravure (2) par rapport au faisceau d'ions (42),
**caractérisé en ce que** le dispositif comprend:
- un système de détection (28, 49) spatio-temporelle d'interactions d'ions (40) du faisceau (42) avec la surface de gravure (2),
- des moyens d'intérruption (24) du faisceau d'ions (42), et
- une unité de traitement (29) reliée aux moyens de déplacement (27), au système de détection (28) et aux moyens d'interruption (24) de faisceau, commandant les opérations successives de détection d'interactions d'ions (40) du faisceau (42) avec la surface de gravure (2), d'interruption du faisceau (42), de déplacement relatif de la surface de gravure (2) par rapport à la position du faisceau (42) et de rétablissement du faisceau (42).

2. Dispositif de gravure selon la revendication 1, **caractérisé en ce qu'**il comprend un système de localisation spatiale (25, 26) du faisceau d'ions (42), interposé entre la source (20) d'ions et la surface de gravure (2).

3. Dispositif de gravure selon l'une des revendications 1 et 2, **caractérisé en ce que** les moyens d'interruption (24) de faisceau comprennent des moyens d'application d'un champ électrique approximativement parallèle à la surface de gravure (2).

4. Dispositif de gravure selon l'une quelconque des revendications précédentes, **caractérisé en ce que** les moyens de guidage (23) comprennent des moyens d'application d'un champ magnétique uniforme (36), déviant le faisceau d'ions (42) de 90°.

5. Dispositif de gravure selon l'une quelconque des revendications précédentes, **caractérisé en ce que** les moyens de déplacement (27) comprennent au moins un élément choisi parmi un quartz piézo-électrique et une céramique, déplaçant le semi-conducteur (1) par rapport au faisceau d'ions (42) incident sur la surface de gravure (2).

6. Dispositif de gravure selon l'une quelconque des revendications précédentes, **caractérisé en ce qu'**il comprend un microscope à effet tunnel, effectuant un contrôle local de conductivité électrique de la surface de gravure (2) traitée.

7. Dispositif de gravure selon l'une quelconque des revendications 1 à 6, **caractérisé en ce qu'**il comprend un microscope à force atomique effectuant un contrôle local topographique de la surface de gravure (2) traitée.

8. Dispositif de gravure selon l'une quelconque des revendications précédentes, **caractérisé en ce que** ladite surface (2) étant occupée par des premières molécules du semi-conducteur ou isolant ayant une première nature chimique ou topographique, la source (20) d'ions est une source d'ions positifs fortement chargés et à basse énergie, et le dispositif de gravure comprend des moyens d'application d'une tension de décélération, donnant aux ions (40) du faisceau (42) une vitesse moyenne commandée, permettant auxdits ions (40), sans rentrer en contact avec la surface de gravure (2) de transformer une pluralité des premières molécules de la surface (2) en des secondes molécules ayant une seconde nature chimique ou topographique, lesdits ions étant rétrodiffusés.

9. Dispositif de gravure selon la revendication 8, **caractérisé en ce que** les premières molécules ayant des liaisons extérieures, lesdites liaisons étant saturées par des atomes d'hydrogène, les moyens d'application de la tension de décélération permettent aux ions (40) du faisceau (42) d'extraire des électrons de ladite pluralité desdites premières molécules de ladite surface (2) et de faire perdre ainsi à ladite pluralité des premières molécules leurs atomes d'hydrogène et de rendre pendantes les liaisons extérieures correspondantes, lesdits ions (40) devenant des atomes creux après avoir extrait des électrons et étant rétrodiffusés, et le dispositif de gravure comprend une source d'un produit saturant les liaisons extérieures pendantes de façon à former lesdites secondes molécules, lesdites secondes molécules étant isolantes, ladite source envoyant le produit vers la surface de gravure (2) suite à un passage du faisceau d'ions (42).

10. Dispositif de gravure selon la revendication 9, **caractérisé en ce que** le système de détection comporte un appareil de mesure (49) de photons émis, lors de passages des électrons extraits d'une couche électronique à une autre des atomes creux.

11. Dispositif de gravure selon l'une des revendications 9 et 10, **caractérisé en ce que** le système de détection détecte des électrons émis par effet Auger par les atomes creux.

12. Dispositif de gravure selon l'une quelconque des revendications 8 à 11, **caractérisé en ce que** le système de détection comporte une surface de détection (28) détectant des propriétés de particules heurtant ladite surface de détection et les ions ou atomes creux rétrodiffusés sont dirigés par es moyens de guidage (23) vers la surface de détection (28).

13. Dispositif de gravure selon l'une quelconque des revendications précédentes, **caractérisé en ce que** le système de détection détecte des fragments ionisés de molécules de la surface de gravure, expulsés sous l'effet desdites interactions.

14. Dispositif de gravure selon l'une quelconque des revendications précédentes, **caractérisé en ce que** le système de détection détecte une gerbe d'électrons émis sous l'effet desdites interactions.

15. Dispositif de gravure selon l'une quelconque des revendications précédentes, **caractérisé en ce que** le système de détection comporte un appareil de mesure de photons émis par des atomes de la surface de gravure (2).

16. Dispositif de gravure selon l'une quelconque des revendications précédentes, **caractérisé en ce que** le système de détection détecte une charge électrique générée dans le semi-conducteur (1) par lesdites interactions.

17. Procédé de gravure par ions permettant de graver une surface de gravure (2) d'un semi-conducteur (1) ou isolant, dans lequel:
- on produit des ions positifs,
- on envoie un faisceau (41) desdits ions vers des moyens de guidage (23),
- on dirige le faisceau d'ions (42) vers la surface de gravure (2) avec les moyens de guidage (23),
- on effectue des déplacements relatifs de la surface de gravure (2) par rapport au faisceau d'ions (42),
**caractérisé en ce que** pour graver la surface de gravure (2), on effectue de manière répétée les opérations suivantes:
- on fait une détection spatio-temporelle d'interactions d'ions (40) du faisceau (42) avec la surface de gravure (2),
- on interrompt le faisceau d'ions (42),
- on effectue un déplacement relatif de la surface de gravure (2) par rapport à la position du faisceau (42), et
- on rétablit le faisceau d'ions (42).

## Patentansprüche

1. lonenätz-Vorrichtung, die es erlaubt, eine Ätzfläche (2) eines Halbleiters (1) oder Isolators zu ätzen, wobei die Vorrichtung Folgendes umfasst:
- eine Quelle (20) positiver lonen,
- Führungsmittel (23) eines Strahls (42) der Ionen (40), die den Strahl (42) zu der Ätzfläche (2) lenken, und
- Mittel zum relativen Bewegen (27) der Ätzfläche (2) in Bezug zu dem lonenstrahl (42),
**dadurch gekennzeichnet, dass** die Vorrichtung Folgendes umfasst:
- ein räumlich-zeitliches Erfassungssystem (28, 49) für Wechselwirkungen der lonen (40) des Strahls (42) mit der Ätzfläche (2),
- Mittel zum Unterbrechen (24) des Ionenstrahls (42) und
- eine Verarbeitungseinheit (29), die mit den Mitteln zum Bewegen (27), dem Erfassungssystem (28) und den Mitteln zum Unterbrechen (24) des Strahls verbunden ist und die aufeinander folgenden Operationen des Erfassens von Wechselwirkungen von Ionen (40) des Strahls (42) mit der Ätzfläche (2), der Unterbrechung des Strahls (42), des relativen Bewegens der Ätzfläche (2) zu der Position des Strahls (42) und des Wiederherstellens des Strahls (42) steuert.

2. Ätzvorrichtung nach Anspruch 1, **dadurch gekennzeichnet, dass** sie ein System zum räumlichen Lokalisieren (25, 26) des lonenstrahls (42)umfasst, das zwischen der lonenquelle (20) und der Ätzfläche (2) eingefügt ist.

3. Ätzvorrichtung nach einem der Ansprüche 1 und 2, **dadurch gekennzeichnet, dass** die Mittel zum Unterbrechen (24) des Strahls Mittel zum Anlegen eines im Wesentlichen zu der Ätzfläche (2) parallelen elektrischen Felds umfassen.

4. Ätzvorrichtung nach einem der vorstehenden Ansprüche, **dadurch gekennzeichnet, dass** die Führungsmittel (23) Mittel zum Anlegen eines gleichförmigen Magnetfelds (36) umfassen, die den lonenstrahl (42) um 90° ablenken.

5. Ätzvorrichtung nach einem der vorstehenden Ansprüche, **dadurch gekennzeichnet, dass** die Mittel zum Bewegen (27) mindestens ein Element umfassen, das aus einem piezo-elektrischen Quarz und einer Keramik ausgewählt ist, welche den Halbleiter (1) bezüglich des lonenstrahls (42), der auf die Ätzfläche (2) auftrifft, bewegen.

6. Ätzvorrichtung nach einem der vorstehenden Ansprüche, **dadurch gekennzeichnet, dass** sie ein Raster-Tunnelmikroskop umfasst, das eine lokale Kontrolle der elektrischen Leitfähigkeit der behandelten Ätzfläche (2) durchführt.

7. Ätzvorrichtung nach einem der Ansprüche 1 bis 6, **dadurch gekennzeichnet, dass** sie ein Abstoßungskraft-Mikroskop umfasst, das eine lokale topographische Kontrolle der behandelten Ätzfläche (2) durchführt.

8. Ätzvorrichtung nach einem der vorstehenden Ansprüche, **dadurch gekennzeichnet, dass** die Oberfläche (2) von ersten Molekülen des Halbleiters oder Isolators belegt ist, die eine erste chemische oder topografische Beschaffenheit haben, dass die lonenquelle (20) eine Quelle stark geladener positiver Ionen mit niedriger Energie ist, und dass die Ätzvorrichtung Mittel zum Anlegen einer Bremsspannung umfasst, die den lonen (40) des Strahls (42) eine gesteuerte mittlere Geschwindigkeit verleiht, die es den lonen (40) erlaubt, ohne mit der Ätzfläche (2) in Berührung zu kommen, eine Vielzahl der ersten Moleküle der Oberfläche (2) in zweite Moleküle umzuwandeln, die eine zweite chemische oder topographische Beschaffenheit haben, wobei die lonen zurückgestreut werden.

9. Ätzvorrichtung nach Anspruch 8, **dadurch gekennzeichnet, dass** die ersten Moleküle externe Verbindungen haben, wobei die Verbindungen durch Wasserstoffatome gesättigt sind, die Mittel zum Anlegen der Bremsspannung der lonen (40) des Strahls (42) erlauben, Elektronen aus der Vielzahl der ersten Moleküle der Oberfläche (2) zu extrahieren und daher die Oberfläche der ersten Moleküle ihre Wasserstoffatome verlieren zu lassen und die entsprechenden externen Verbindungen hängend zu machen, wobei die lonen (40) hohle Atome werden, nachdem sie Elektronen extrahiert haben, und zurückgestreut werden, und wobei die Ätzvorrichtung eine Quelle eines Produkts umfasst, die die hängenden externen Verbindungen so sättigt, dass die zweiten Moleküle gebildet werden, wobei die zweiten Moleküle isolierend sind, wobei die Quelle das Produkt nach einem Passieren des lonenstrahls (42) zu der Ätzfläche (2) sendet.

10. Ätzvorrichtung nach Anspruch 9, **dadurch gekennzeichnet, dass** das Erfassungssystem ein Messgerät (49) für Photonen umfasst, die bei Passagen der Elektronen, die aus einer elektronischen Schicht zu einer anderen elektronischen Schicht der hohlen Atome extrahiert werden, gesendet werden.

11. Ätzvorrichtung nach einem der Ansprüche 9 und 10, **dadurch gekennzeichnet, dass** das Erfassungssystem Elektronen erfasst, die durch den Auger-Effekt von den hohlen Atomen gesendet werden.

12. Ätzvorrichtung nach einem der Ansprüche 8 bis 11, **dadurch gekennzeichnet, dass** das Erfassungssystem eine Erfassungsfläche (28) umfasst, die Eigenschaften von Partikeln erfasst, die auf die Erfassungsfläche prallen, und dass die zurückgestreuten Ionen oder Atome von den Führungsmitteln (23) der Erfassungsfläche (28) gelenkt werden.

13. Ätzvorrichtung nach einem der vorstehenden Ansprüche, **dadurch gekennzeichnet, dass** das Erfassungssystem ionisierte Fragmente von Molekülen der Ätzfläche erfasst, die unter der Wirkung der Wechselwirkungen ausgetrieben werden.

14. Ätzvorrichtung nach einem der vorstehenden Ansprüche, **dadurch gekennzeichnet, dass** das Erfassungssystem einen Schauer von Elektronen erfasst, der unter der Einwirkung der Wechselwirkungen gesendet wird.

15. Ätzvorrichtung nach einem der vorstehenden Ansprüche, **dadurch gekennzeichnet, dass** das Erfassungssystem ein Messgerät für Photonen umfasst, die von den Atomen der Ätzfläche (2) gesendet werden.

16. Ätzvorrichtung nach einem der vorstehenden Ansprüche, **dadurch gekennzeichnet, dass** das Erfassungssystem eine elektrische Ladung erfasst, die in dem Halbleiter (1) von den Wechselwirkungen erzeugt wird.

17. Ionenätz-Verfahren, das es erlaubt, eine Ätzfläche (2) eines Halbleiters (1) oder Isolators zu ätzen, bei welchem:
- man positive lonen erzeugt,
- man einen Ionenstrahl (41) zu Führungsmitteln (23) sendet,
- man den lonenstrahl (42) mit den Führungsmitteln (23) zu der Ätzfläche (2) lenkt,
- man relative Bewegungen der Ätzfläche (2) zu dem lonenstrahl (42) durchführt,
**dadurch gekennzeichnet, dass** man zum Ätzen der Ätzfläche (2) wiederholt die folgenden Operationen durchführt:
- Durchführen einer räumlich-zeitlichen Erfassung von Wechselwirkungen von lonen (40) des Strahls (42) mit der Ätzfläche (2),
- Unterbrechen des Ionenstrahls (42),
- Bewirken eines relativen Bewegens der Ätzfläche (2) bezüglich der Position des Strahls (42) und
- Wiederherstellen des lonenstrahls (42).

## Claims

1. An ion beam etching device enabling to produce an etched surface (2) on a semiconductor (1) or an insulator, said device comprising:
- a positive ion source (20),
- means (23) for guiding a beam (42) of the said ions (40) thereby directing the said beam (42) to the etched surface (2), and
- means (27) for displacing the etched surface (2) relatively to the ion beam (42),
**characterised in that** the device comprises:
- a system for space-time detection (28, 49) of ion interactions (40) of the beam (42) with the etched surface (2),
- means (24) for interrupting the ion beam (42), and
- a processing unit (29) linked to the displacement means (27), to the detection system (28) and the beam interruption means (24), controlling the successive operations of: detecting the interactions of the ions (40) in the beam (42) with the etched surface (2), interruption of the beam (42), relative displacement of the etched surface (2) in relation to the position of the beam (42) and restoring the beam (42).

2. An etching device according to claim 1, **characterised in that** it comprises a system for spatial localisation (25, 26) of the ion beam (42), interposed between the ion source (20) and the etched surface (2).

3. An etching device according to one of claims 1 and 2, **characterised in that** the beam interrupting means (24) comprise means for applying an electric field that is more or less parallel to the etched surface (2).

4. An etching device according to any one of the previous claims, **characterised in that** the guiding means (23) comprise means for applying a uniform magnetic field (36), diverting the ion beam (42) by 90°.

5. An etching device according to any one of the previous claims, **characterised in that** the displacing means (27) comprise at least one element selected among a piezoelectric quartz and a ceramic, thereby displacing the semiconductor (1) with respect to the ion beam (42) incident on the etched surface (2).

6. An etching device according to any one of the previous claims, **characterised in that** it comprises a tunnel effect microscope, controlling the etched surface processed (2) for local electric conductivity.

7. An etching device according to any one of claims 1 to 6, **characterised in that** it comprises an atomic strength microscope, performing local topographic control of the etched surface processed (2).

8. An etching device according to any one of the previous claims, **characterised in that** the said surface (2) is occupied by first molecules of the semiconductor or insulator having a first chemical or topographic nature, the ion source (20) is a source of highly charged and low energy positive ions and the etching device comprises means for applying a deceleration voltage, giving the ions (40) of the beam (42) an average controlled velocity, enabling these ions (40), without contacting the etched surface (2), to transform a plurality of the first molecules of the surface (2) into second molecules with a second chemical or topographic nature, whereby these ions are back-scattered.

9. An etching device according to claim 8, **characterised in that** the first molecules having external links, whereas the said links are saturated by hydrogen atoms, the means for applying the deceleration voltage enable the ions (40) of the beam (42) to extract electrons from the said plurality of the first molecules of the said surface (2) and to make thus the plurality of the first molecules lose their atoms of hydrogen and to make the corresponding external links pending, whereas the said ions (40) become hollow atoms after having extracted electrons and are back-scattered, and the etching device comprises a source of a product saturating the pending external links in order to form the said second molecules, whereas these second molecules are insulating, the source sends the product toward the etched surface (2) further to a passage of the ion beam (42).

10. An etching device according to claim 9, **characterised in that** the detection system comprises an instrument (49) for measuring the photons transmitted as the electrons extracted from one electronic layer switch to another of the hollow atoms.

11. An etching device according to one of claims 9 and 10, **characterised in that** the detection system detects electrons transmitted by Auger effect by the hollow atoms.

12. An etching device according to any one of claims 8 to 11, **characterised in that** the detection system comprises a detection surface (28) detecting the properties of the particles bumping against the detection surface and the back-scattered ions or hollow atoms are directed by the guiding means (23) towards the detection surface (28).

13. An etching device according to any one of the previous claims, **characterised in that** the detection system detects ionised fragments of molecules of the etched surface, sputtered under the effect of the said interactions

14. An etching device according to any one of the previous claims, **characterised in that** the detection system detects a burst of electrons transmitted under the effect of the said interactions.

15. An etching device according to any one of the previous claims, **characterised in that** the detection system comprises an instrument for measuring the photons transmitted by atoms from the etched surface (2).

16. An etching device according to any one of the previous claims, **characterised in that** a detection system detects an electric charge generated in the semiconductor (1) by the said interactions.

17. An ion beam etching method enabling to produce an etched surface (2) on a semiconductor (1) or insulator, wherein
- positive ions are produced,
- a beam (41) of the said ions is sent towards guiding means (23),
- the ion beam (42) is directed to the etched surface (2) using the guiding means (23),
- the etched surface (2) is moved relatively to the ion beam (42),
**characterised in that** the following operations are performed iteratively in order to etch the surface (2):
- interactions of ions (40) of the beam (42) with the etched surface (2) are detected spatially and temporally,
- the ion beam (42) is interrupted,
- the etched surface (2) is moved relatively to the position of the beam (42), and
- the ion beam (42) is restored.
